# EUROPÄISCHE PATENTSCHRIFT

(11) **EP 1 495 590 B1**
(45) Veröffentlichungstag und Bekanntmachung des Hinweises auf die Patenterteilung: **19.10.2005**
(21) Anmeldenummer: 03724954.7
(22) Anmeldetag: 04.04.2003
(51) Int. Cl.: H04L 12/413

(54) **NETZWERK MIT EINEM VERBINDUNGS-NETZWERK AND MEHREREN MIT DEM VERBINDUNGS-NETZWERK GEKOPPELTEN NETZKNOTEN**
NETWORK COMPRISING AN INTERCONNECTING NETWORK AND SEVERAL NETWORK NODES THAT ARE COUPLED TO SAID INTERCONNECTING NETWORK
RESEAU COMPRENANT UN RESEAU DE LIAISON ET PLUSIEURS NOEUDS DE RESEAU COUPLES AUDIT RESEAU DE LIAISON

(30) Priorität: 16.04.2002 DE 10216984
(43) Veröffentlichungstag der Anmeldung: 12.01.2005
(73) Patentinhaber: ROBERT BOSCH GMBH, 70469 Stuttgart (DE); Decomsys - Dependable Computer Systems, Hardware und Software Entwicklung GmbH, 1060 Wien (AT); Philips Intellectual Property & Standards GmbH, 52066 Aachen (DE); Koninklijke Philips Electronics N.V., 5621 BA Eindhoven (NL); DaimlerChrysler AG, 70567 Stuttgart (DE); Bayerische Motorenwerke AG, 80788 München (DE); GENERAL MOTORS CORPORATION, Warren, MI 48090-9010 (US); Freescale Semiconductor, Inc., Austin, Texas 78735 (US)
(72) Erfinder: FUHRMANN, Peter, 52080 Aachen (DE); POKORNY, Gregor, A-1120 Wien (AT); BELSCHNER, Ralf, 72124 Pleizhausen (DE); HEDENETZ, Bernd, 72770 Denkendorf (DE); SCHEDL, Anton, 80798 München (DE); BERWANGER, Josef, 85586 Poing (DE); PELLER, Martin, 80796 München (DE); FÜHRER, Thomas-Peter, 70849 Gerlingen (DE); MILLSAP, Arnold, Leonard, MI 48367 (US); FOREST, Thomas, Macomb, MI 48042-2213 (US); TEMPLE, Christopher, 81825 München (DE)
(74) Vertreter: Wörz, Volker Alfred
(86) Internationale Anmeldenummer: PCT/EP2003/003506
(87) Internationale Veröffentlichungsnummer: WO 2003/088590

(56) Entgegenhaltungen:
- US-A- 4 628 311
- US-A- 4 747 100

## Beschreibung

Die Erfindung bezieht sich auf ein Netzwerk mit einem Verbindungs-Netzwerk und mehreren mit dem Verbindungs-Netzwerk gekoppelten Netzknoten, die vor der Einbindung als.aktiver Netzknoten jeweils zur Anpassung ihres lokalen Kommunikationszeitplans zu den Kommunikationszeitplänen wenigstens eines anderen Netzknoten vorgesehen sind.

Ein solches Netzwerk ist in der Kraftfahrzeugtechnik einsetzbar und kann beispielsweise aus der Zeitschrift "Elektronik", Nr. 14, 1999, Seiten 36 bis 43 (Dr. Stefan Polenda, Georg Kroiss: "TTP: "Drive by Wire" in greifbarer Nähe") entnommen werden, bei dem das TTP-Protokoll (TTP = Time-Triggered Protocol) verwendet werden. Dieses Protokoll ermöglicht eine sichere Datenübertragung und kann daher auch in Netzwerken für sicherheitsrelevante Vorrichtungen (z.B. Bremsen) gebraucht werden.

Ein solches Netzwerk ist auch aus Dokument US 4 747 100 bekannt.

Der Erfindung liegt die Aufgabe zugrunde, ein Netzwerk mit einem Verbindungs-Netzwerk und mehreren mit dem Verbindungs-Netzwerk gekoppelten Netzknoten zu schaffen, welches nach dem Start des Netzwerks eine Synchronisation der Netzknoten ermöglicht.

Die Aufgabe wird durch ein Netzwerk der eingangs genannten Art mit folgenden Merkmalen gelöst:
Das Netzwerk enthält ein Verbindungs-Netzwerk und mehreren mit dem Verbindungs-Netzwerk gekoppelte Netzknoten, die vor der Einbindung als aktiver Netzknoten jeweils zur Anpassung ihres lokalen Kommunikationszeitplans zu den Kommunikationszeitplänen wenigstens eines anderen Netzknoten vorgesehen sind, wobei ein einzubindender Netzknoten zur Prüfung von Aktivität anderer Netzknoten und bei Feststellung keiner Aktivität als Referenz-Netzknoten fest zur Sendung in seinem Kommunikationszeitplan vorgegebene Positionsnachrichten für andere Netzknoten vorgesehen ist und ein Netzknoten zur Einbindung als aktiver Netzknoten nach Erhalt von Positionsnachrichten zur Anpassung seines lokalen Kommunikationszeitplans an den des Referenz-Netzknotens und bei Abschluss einer positiven Prüfung auf Übereinstimmung seines eigenen Kommunikationszeitplans mit den Kommunikationszeitplänen wenigstens eines Teils der aktiven Netzknoten vorgesehen ist.

Die Erfindung bezieht sich auf ein Netzwerk, das nach einem Start oder Hochfahren des Netzwerks eine fehlertolerante Synchronisation der über ein Verbindungs-Netzwerk gekoppelten Netzknoten sicherstellt. Das Verbindungs-Netzwerk kann eine beliebige Netzwerktopologie aufweisen und von den Netzknoten kommende oder zu den Netzknoten gehende Nachrichten ohne oder mit Signalverstärkung weiterleiten. Als Netzwerktopologie kommt ein verteilter, synchrone Datenbus, ein Stemkoppler usw. in Betracht.

In den Netzknoten des Netzwerks muss ein gemeinsamer Kommunikationszeitplan aufgebaut werden. Erfindungsgemäß ergibt sich dynamisch zur Laufzeit, welcher Netzknoten versucht, den Kommunikationszeitplan für alle anderen Netzknoten vorzugeben. Dabei kann auf einen statisch bestimmten, besonders ausgezeichneten Netzknoten, der immer und als einziger den globalen Kommunikationszeitplan vorgibt um damit die initiale Synchronisation der lokalen Kommunikationszeitpläne zu ermöglichen, verzichtet werden.

Der Kommunikationszeitplan stellt einen zeitlichen Ablauf für den Datenaustausch dar, welcher genau beschreibt, wann welcher Netzknoten bestimmte Daten an die anderen Netzknoten und das Verbindungs-Netzwerk weitergibt. Dieser ist in seiner zeitlichen Ausprägung nicht während des Betriebes sondern schon zuvor festgelegt worden ist. Der gesamte Datenaustausch zwischen den Netzknoten ist in diesen zeitlichen Rahmen eingebettet.

Mit Hilfe von Positionsnachrichten, die jeder Netzknoten zu einem bestimmten, von seinem jeweiligen lokalen Kommunikationsplan vorgegebenen Zeitpunkt sendet, wird die Synchronisation ermöglicht. Der Netzknoten, welcher keine Positionsnachrichten von anderen Netzknoten empfängt, wird der Referenz-Netzknoten für später einzubindende bzw. zu synchronisierende Netzknoten. Die anderen Netzknoten versuchen dann jeweils ihren lokalen Kommunikationsplan an den des Referenz-Netzknotens anzupassen. Hat ein Netzknoten die Positionsnachrichten des Referenz-Netzknotens erhalten und sich mit seinem lokalen Kommunikationszeitplan an den des Referenz-Netzknotens angepasst, wird erfindungsgemäß eine Prüfphase angeschlossen. In dieser Prüfphase wird ermittelt, ob die zuvor getroffene Anpassung korrekt ist und erst bei einem positiven Ergebnis als aktiver Netzknoten eingebunden, der seine eigenen Positionsnachrichten aussendet.

Durch die Erfindung wird sichergestellt, dass die Netzknoten einen gemeinsamen Kommunikationsplan etablieren. Dabei kann auf einen statisch bestimmten, besonders ausgezeichneten Netzknoten, der immer und als einziger den globalen Kommunikationszeitplan vorgibt um damit die Anfangs-Synchronisation der lokalen Kommunikationszeitpläne ermöglicht, verzichtet werden. Der Netzknoten, der versucht, den Kommunikationszeitplan für alle Netzknoten vorzugeben ergibt sich dynamisch zur Laufzeit.

Es wird verhindert, dass ein Netzknoten seinen Kommunikationszeitplan mit einem einzelnen, im Vergleich zu den anderen aktiven Netzknoten fehlerhaft operierenden Netzknoten synchronisiert. Ein sich einbindender Netzknoten wählt den ersten Netzknoten als Referenz-Netzknoten, von dem eine Nachricht empfangen wird, mit deren Hilfe die aktuelle Position im Kommunikationszeitplan bestimmbar ist. Erst nach dem Anpassen des eigenen Kommunikationszeitplans wird die dann etablierte eigene Sicht gegen die aller anderen, verfügbaren Netzknoten verglichen. Lediglich, wenn bestimmbar ist, dass der lokale Kommunikationszeitplan des Netzknotens mit dem globalen Kommunikationszeitplan übereinstimmt, kann dieser aktiv an der Kommunikation teilnehmen und in den synchronisierten Normalbetrieb übergehen. Da im ersten Schritt lediglich die Information eines Netzknotens, d.h. des Referenz-Netzknotens, ausgewertet werden muss, und nicht alle verfügbaren Knoten für die Anfangs-Synchronisation des lokalen Kommunikationszeitplans herangezogen werden, kann das im Netzwerk betriebene Verfahren mit wenig Aufwand realisiert werden. Maßnahmen zur fehlertoleranten Auswertung müssen in dieser Phase noch nicht angewendet werden. Durch die abschließende Prüfphase wird aber die Fehlertoleranz für das Gesamtverfahren sichergestellt.

Ein Netzknoten ist bei der Prüfung auf Übereinstimmung seines eigenen Kommunikationszeitplans mit den Kommunikationszeitplänen wenigstens eines Teils der aktiven Netzknoten zur Zählung der Übereinstimmungen und der Abweichungen vorgesehen. Dieser wird nur aktiver Netzknoten eingebunden, wenn die Zahl der Übereinstimmungen größer als die Zahl der Abweichungen ist oder keine Abweichung vorliegt.

Ferner ist der Netzknoten für die Prüfung auf Übereinstimmung seines eigenen Kommunikationszeitplans mit den Kommunikationszeitplänen wenigstens eines Teils der aktiven Netzknoten zur Verwendung eines Zeitintervalls vorgesehen, in dem wenigstens einmal alle Positionsnachrichten der anderen an der Kommunikation beteiligten Netzknoten ausgesendet werden.

Nach Detektion von keiner Aktivität ist ein einzubindender Netzknoten zur Prüfung vorgesehen, ob ein weiterer Netzknoten sich als Referenz-Netzknoten einbinden möchte. Hierbei kann eine Kollisionsnachricht verwendet werden. Für eine Situation, in der mindestens zwei Netzknoten parallel versuchen eine Kommunikation erstmals zu starten, ist keine Kollisionserkennung notwendig, da das erfindungsgemäße Netzwerk sicherstellt, dass nach einer Auflösungsphase nur ein Netzknoten als aktiver Knoten am Netzwerk verbleibt. Hierbei ist ein Netzknoten zuerst zur Aussendung seiner eigenen Positionsnachricht, zur Zählung von eintreffenden Positionsnachrichten und nur dann zur Einbindung als Referenz-Netzknoten vorgesehen ist, wenn die Zahl der korrekt empfangenen Positionsnachrichten größer als die Zahl der nicht korrekt empfangenen Positionsnachrichten ist oder alle Positionsnachrichten korrekt empfangen werden.

Die Erfindung bezieht sich auch auf einen Netzknoten in einem Netzwerk mit einem Verbindungs-Netzwerk und mehreren weiteren mit dem Verbindungs-Netzwerk gekoppelten Netzknoten und auf ein Verfahren zur Einbindung eines Netzknotens als aktiver Netzknoten in einem Netzwerk mit einem Verbindungs-Netzwerk und mehreren weiteren mit dem Verbindungs-Netzwerk gekoppelten Netzknoten,.

Ausführungsbeispiele der Erfindung werden nachstehend anhand der Fig. näher erläutert. Es zeigen:
- Fig. 1: ein Netzwerk mit mehreren Netzknoten und ein Verbindungs-Netzwerk,
- Fig. 2 und 6: zwei in einem Netzknoten anwendbare Ablaufdiagramme und
- Fig. 3 bis 5: verschiedene Zeitdiagramme zur Erläuterung des erfindungsgemäßen Netzwerks.

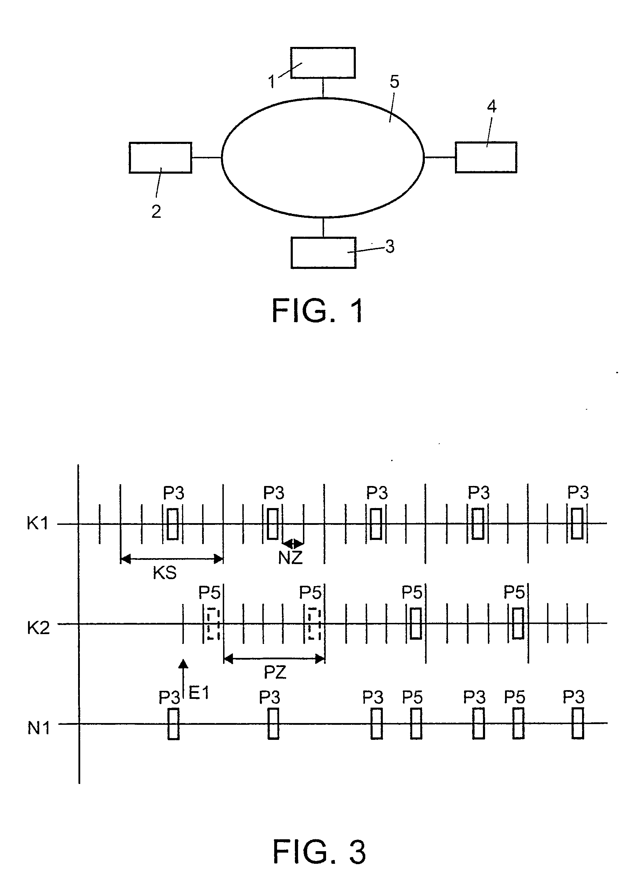

Ein Ausführungsbeispiel des erfindungsgemäßen Netzwerks ist in Fig. 1 dargestellt. Dieses Netzwerk enthält beispielsweise vier Netzknoten 1 bis 4, die jeweils mit einem Verbindungs-Netzwerk 5 gekoppelt sind. Das Verbindungs-Netzwerk 5 repräsentiert eine beliebige Vernetzung der angeschlossenen Netzknoten 1 bis 4. Über dieses Verbindungs-Netzwerk 5 tauschen die angeschlossenen Netzknoten 1 bis 4 Nachrichten in der Form aus, dass die Nachricht eines sendenden Netzknotens von allen angeschlossenen Netzknoten empfangen werden kann. Das Verbindungs-Netzwerk 5 kann eine beliebige Netzwerktopologie aufweisen und die Nachrichten ohne (passiv) oder mit (aktiv) Signalverstärkung weiterleiten. Ein Verbindungs-Netzwerk als aktiver Sternkoppler ist beispielsweise aus EP 1 179 921 A2 bekannt. Die Nachrichtenübertragung kann dabei über verschiedene Übertragungsmedien erfolgen (drahtgebundene elektrische, optische Übertragung oder drahtlose Übertragung beispielsweise eine Funk- oder Infrarot-Übertragung). Das Verbindungs-Netzwerk kann auch mehr als einen Kanal zur Kommunikation umfassen, d.h., z.B. als redundant ausgelegtes Verbindungs-Netzwerk mit zwei oder mehr Kommunikationskanälen bestehen.

Jeder Netzknoten 1 bis 4 umfasst mindestens eine nicht dargestellte Kommunikationsschnittstelle, die den Austausch von Nachrichten über das Verbindungs-Netzwerk 5 sicherstellt, und eine ebenfalls nicht dargestellte Steuer- und Verarbeitungseinheit, welche die Kommunikationsschnittstelle konfigurieren und ansteuern kann. Die Steuer- und Verarbeitungseinheit bestimmt, wann der zugehörige Netzknoten an der Kommunikation über das Verbindungs-Netzwerk 5 teilnehmen darf (Freigabe), und welche Daten mit Hilfe der Nachrichten übertragen werden bzw. wie die empfangenen Nachrichteninhalte (Nutzdaten) verarbeitet werden sollen.

Für viele Kontroll- und Automatisierungsanwendungen, die über ein solches Verbindungs-Netzwerk 5 Anwendungsdaten austauschen, muss gewährleistet werden, dass diese Anwendungsdaten mit einer festgelegten, zeitlichen Vorhersagbarkeit jedem Netzknoten (1 bis 4) bzw. Teilnehmer zur Verfügung stehen. Unter dieser Voraussetzung verursachen Anwendungsdaten, die nur in Verbindung mit ihrem zeitlichen Auftreten bzw. der Reihenfolge, in der sie mit anderen Daten verarbeitet werden müssen, eine spezifizierte System- bzw. Anwendungsfunktion.

Die Anforderung für das vorhersagbare Auftreten von Nachrichten in einem Netzwerk wird beispielsweise durch die sogenannte "zeitgesteuerte Kommunikation" oder durch ein "zeitgesteuertes Protokoll" erfüllt. Ein zeitgesteuertes Protokoll basiert auf einem Kommunikationszeitplan, der in seiner zeitlichen Ausprägung nicht während des Betriebes sondern schon zuvor festgelegt worden ist. Der gesamte Datenaustausch zwischen den Netzknoten 1 bis 4 ist in diesen zeitlichen Rahmen eingebettet. Es entsteht ein zeitlicher Ablauf für den Datenaustausch (Kommunikationszeitplan), welcher genau beschreibt, wann welcher Netzknoten bestimmte Daten an die anderen Netzknoten (1 bis 4) und das Verbindungs-Netzwerk 5 weitergibt. Der Kommunikationszeitplan kann auch einen reservierten Abschnitt enthalten, in dem die Nachrichtenabfolge dynamisch, zur Laufzeit bestimmt wird. Für die weitere Betrachtung ist ein solcher Abschnitt innerhalb des Kommunikationszeitplans jedoch nicht relevant und wird lediglich als reservierter Bereich behandelt.

Um diesen Kommunikationszeitplan zu realisieren, muss auch für den Zugriff auf das Kommunikationsmedium (Verbindungs-Netzwerk) eine strikte Vorhersagbarkeit sichergestellt werden. Häufig wird dafür das TDMA-Verfahren (Time Division Multiple Access) angewendet. Der konfliktfreie Zugriff auf ein gemeinsames Kommunikationsmedium wird dadurch geregelt, dass ein Netzknoten lediglich für einen kurzen Abschnitt, der als Nachrichtenslot oder Nachrichtenzeitschlitz bezeichnet wird, innerhalb eines zeitlichen Intervalls das exklusive Senderecht erhält. Bei einer statischen Zuteilung der Sendeberechtigung umfasst das Gesamtintervall, das als Kommunikationszyklus bezeichnet wird, die Nachrichtenzeitschlitze für sämtliche Netzknoten und wiederholt sich dann periodisch. Kommunikationsprotokolle lassen hierbei auch zu, dass ein Netzknoten mehrere Nachrichtenzeitschlitze innerhalb eines Kommunikationszyklus zugeteilt bekommt.

In einem TDMA-basierten Kommunikationssystem (Netzwerk) benötigt jeder Netzknoten eine gemeinsame, unter allen Teilnehmern abgestimmte Zeitinformation, die beispielsweise durch einen zentralen Netzknoten (Time-Server) an alle anderen Netzknoten verteilt werden kann. Für sicherheitsrelevante und fehlertolerante Systeme (z.B. elektronisches Bremssystem im Kraftfahrzeug) ist jedoch ein zentraler Netzknoten ungeeignet, da ein Ausfall dieser Komponente die gesamte Kommunikation zum Erliegen bringt. Zeitgesteuerte Protokolle, wie z.B. das TTP-Verfahren (Time-Triggered Protocol) definieren für die einzelnen Netzknoten jeweils eine lokale Uhrzeit, die mit anderen Systemteilnehmern zu einer globalen Übereinstimmung synchronisiert werden. Dazu wird für die globale Uhrzeit eine im System einheitlich zu verwendende Granularität bzw. Auflösung festgelegt. Es muss garantiert werden, dass alle Netzknoten, bezogen auf die festgelegte Auflösung, über eine einheitliche Sicht der globalen Uhrzeit verfügen. Im synchronisierten Normalbetrieb bestimmt jeder Netzknoten während einer Messphase die Abweichungen der lokalen Uhr von der im Netzknoten präsenten lokalen Uhrzeit der anderen Netzknoten. Dabei wird nach Empfang einer Synchronisationsnachricht der jeweilige entsprechende Empfangszeitpunkt mit dem aus der lokalen Uhr abgeleiteten Erwartungszeitpunkt verglichen. Durch die Auswertung aller verfügbaren Abweichungen zu den anderen, jeweils durch ihre Synchronisationsnachrichten repräsentierten Netzknoten, kann jeder Netzknoten Korrekturterme bestimmen. Hiermit kann die Frequenz des Uhrentaktes der lokalen Uhr zeitweilig oder dauerhaft angepasst und auch noch zusätzlich eine über die Messphase aufsummierte Verschiebung der Phasenlagen zwischen den lokalen Kommunikationszeitplänen der jeweiligen Netzknoten in einer Korrekturphase ausgeglichen werden. Die Lage der Messphase sowie der Korrekturphase, die sich überlappen können, muss in allen Knoten synchronisiert sein.

Die Verarbeitung des Kommunikationszeitplans eines Netzknotens basiert auf seinem lokalen Uhrentakt. Die Länge eines lokalen Kommunikationszyklus ist also abhängig vom lokalen Uhrentakt. Über die globale Uhrensynchronisation im synchronisierten Normalbetrieb werden die lokalen Kommunikationszyklen in einer globalen Übereinstimmung gehalten.

Bei allen Kommunikationssystemen (Netzwerken), deren Medienzugriffsverfahren die Synchronisierung der beteiligten Netzknoten voraussetzt, müssen geeignete Verfahren sicherstellen, dass die Netzknoten nach ihrer Aktivierung aus dem unsynchronisierten Zustand in den synchronisierten Zustand übergehen. Im synchronisierten Zustand decken sich die in den Netzknoten lokal verwalteten Kommunikationszeitpläne, so dass jeder aktive Netzknoten seine reservierten Nachrichtenzeitschlitze verwenden kann und eine von diesem gesendete Nachricht auch bei allen anderen Netzknoten in den gleichen, für diese Übertragung reservierten Nachrichtenzeitschlitz fällt.

In den Netzknoten 1 bis 4 des Netzwerks muss ein gemeinsamer Kommunikationszeitplan aufgebaut werden. Erfindungsgemäß ergibt sich dynamisch zur Laufzeit, welcher Netzknoten versucht, den Kommunikationszeitplan für alle anderen Netzknoten vorzugeben.

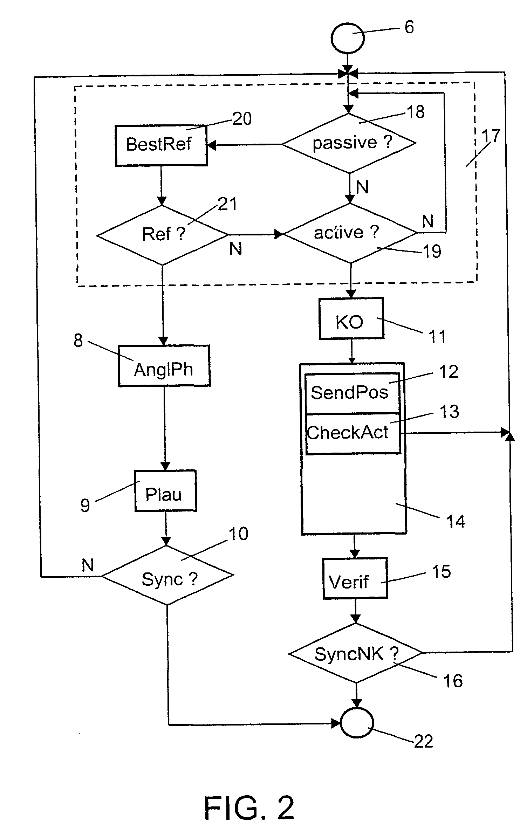

Mit Hilfe des in Fig. 2 dargestellten Ablaufdiagramms wird die Synchronisation aller Netzknoten auf einem globalen Kommunikationszeitplan gezeigt.

Vor der Freigabe durch eine übergeordnete, nicht näher dargestellte Steuereinheit werden alle notwendigen Einstellungen für die Teilnahme an der Kommunikation durch die Steuereinheit an den Netzknoten vorgenommen. Jeder Netzknoten kennt damit den globalen Kommunikationszeitplan und die eigenen zur Sendung von Nachrichten zu verwendenden Nachrichtenzeitschlitze innerhalb dieses Kommunikationszeitplans.

Ist ein Netzknoten durch die übergeordnete Steuereinheit freigegeben worden (Kreis 6 in Fig. 2), muss sich der Netzknoten entscheiden, welche Funktion er im Netzwerk übernimmt. Ein Netzknoten hat zwei Möglichkeiten zum Übergang in den synchronisierten Normalbetrieb. Entweder durchläuft der Netzknoten einen ersten Pfad im Ablaufdiagramm mit den Blöcken 8 bis 10, in dem dieser seinen lokalen Kommunikationszeitplan zu dem mindestens eines anderen, aktiv Positionsnachrichten versendenden Netzknotens synchronisiert, oder einen zweiten Pfad mit den Blöcken 11 bis 16, in dem er selbst aktiv versucht eine Kommunikation zu beginnen. Es sei erwähnt, dass im synchronisierten Zustand des Netzwerks alle Netzknoten oder nur bestimmte Netzknoten (definierte Untermenge von Netzknoten) mindestens eine Positionsnachricht pro Kommunikationszyklus senden. Die Positionsnachrichten sind regulärer Teil des globalen Kommunikationszeitplans.

Die Entscheidung, für welchen Pfad sich ein Netzknoten entscheidet, wird in einem übergeordneten gestrichelt in Fig. 2 eingezeichneten Block 17 getroffen. Die durch Block 17 repräsentierte Phase behandelt eine Netzwerkbeobachtung und die Auswahl des ersten oder zweiten Pfads. Nach der Freigabe durch die übergeordnete Steuereinheit beginnt ein Netzknoten nicht sofort zu senden, sondern wartet für ein vorgegebenes Beobachtungs-Zeitintervall, ob er irgendeine Nachricht erhält. Dies zeigt ein Abfrageblock 18 symbolisch durch die Abfrage "passive ?" . Findet keine Aktivität im Netzwerk statt und hat der Netzknoten damit eine Ruhephase festgestellt, überprüft er ob er selbst aktiv werden kann. Dies ist in Abfrageblock 19 durch "active ?" dargestellt. Wird diese Frage bejaht geht der Netzknoten in den Pfad 2 zu Block 11. Solange eine solches Beobachtungs-Zeitintervall ohne jegliche Netzwerkaktivität nicht beobachtet wurde, wird durch den Abfrageblock 19 der Netzknoten wieder zum Block 18 zurückverwiesen. Das Beobachtungs-Zeitintervall muss so groß gewählt werden, dass ein unsynchronisierter Netzknoten im fehlerfreien Fall einen anderen Netzknoten, der gemäß dem Kommunikationszeitplan Sendeaktivität erzeugt, als bereits aktiven Netzknoten wahrnimmt.

Jede Aktivität im Netzwerk, die von einem Netzknoten empfangen wird, führt dazu, dass das Beobachtungs-Zeitintervall von neuem gestartet wird. Nachrichten, die für die Integration des Netzknotens nicht herangezogen werden können, führen also genauso zu einem Neustart des Beobachtungs-Zeitintervalls wie Störungen, die ein eventuelles Störfilter im Empfangspfad des Netzknotens überwunden haben.

Wird innerhalb dieses Beobachtungs-Zeitintervalls jedoch eine Positionsnachricht empfangen, so verzweigt der Netzknoten an dem Abfrageblock 18 zu einem Block 20. Der Empfang einer Positionsnachricht ermöglicht es dem Netzknoten die Phasenlage seines lokalen Kommunikationszeitplans an den globalen Kommunikationszeitplan des Netzknotens (Referenz-Netzknoten) anzugleichen, von dem die Positionsnachricht gesendet worden ist.

Der globale Kommunikationszeitplan definiert sich dadurch, dass alle aktiven Netzknoten gemäß ihrem lokalen Kommunikationszeitplan ihre Nachrichten absetzen. Wenn diese Netzknoten alle synchronisiert sind, ist im Netzwerk ein einheitlicher, globaler Kommunikationszeitplan zu beobachten.

Durch den Empfang einer Positionsnachricht eines Referenz-Netzknotens kann ein Netzknoten, der bislang noch keinen synchronisierten Kommunikationszeitplan abarbeitet und daher auch noch nicht aktiv am Sendegeschehen teilnimmt, die Phasenlage des globalen Kommunikationszeitplans ableiten. Da er lediglich eine Information über die Phasenlage des lokalen Kommunikationszeitplans des ausgewählten Referenz-Netzknotens erhält, so gilt dies nur dann, wenn der lokale Kommunikationszeitplan des Referenz-Netzknotens mit dem globalen Kommunikationszeitplan übereinstimmt.

Es wird zunächst davon ausgegangen, dass diese Annahme (Referenz-Netzknoten gibt globalen Kommunikationszeitplan vor) gültig ist und erst in einer späteren Phase, jedoch noch vor dem Eintritt in den synchronisierten Normalbetrieb (noch bevor der Netzknoten aktiv am Kommunikationsgeschehen teilnehmen darf) wird diese Annahme geprüft und die Entscheidung gegebenenfalls revidiert.

Aus der Positionsnachricht wird der zugehörige Sende-Netzknoten bestimmt und als Referenz-Netzknoten gespeichert (in Block 20 durch "BestRef" angedeutet). Ist lediglich eine Positionsnachricht für einen Netzknoten im Kommunikationszeitplan zulässig, so kann auf die Bestimmung des Referenz-Netzknotens verzichtet werden und die Positionsinformation, z.B. die Nummer des Nachrichtenzeitschlitzes, zur eindeutigen Referenzidentifikation gespeichert werden. Diese Information ist dann gleichbedeutend mit dem Wissen über den zugehörigen Sende-Netzknoten und ermöglicht eine eindeutige Identifikation der von diesem Netzknoten stammenden Positionsinformation zur Synchronisation der Kommunikationszeitpläne.

In dem dem Block 20 folgenden Abfrageblock 21, der ebenso wie die Blöcke 18 bis 20 Bestandteil des Blockes 17 sind, wird bestimmt, ob der selektierte Referenz-Netzknoten als Referenz zur Anpassung der Phasenlage des eigenen, lokalen Kommunikationszeitplans an den des Referenz-Netzknotens verwendet werden darf (dargestellt durch "Ref ?"). Diese Abfrage wird jedoch erfolgreich passiert, da für den ersten Integrationsversuch (Eintritt in den ersten Pfad) noch keine Einschränkungen bzgl. der zulässigen Referenz-Netzknoten bestehen. Diese Einschränkungen entstehen erst dadurch, dass für den Fall einer fehlgeschlagenen Integration, d.h., dem Verlassen des ersten Pfades und den Wiedereintritt in den Block 17, der zugehörige Referenz-Netzknoten nicht direkt wieder für einen weiteren Integrationsversuch verwendet werden darf.

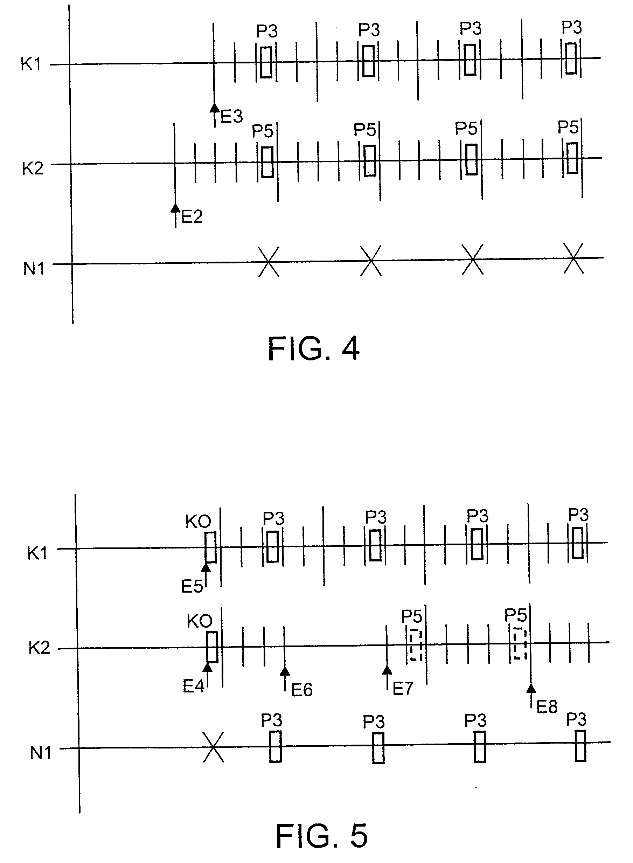

Mit dem Eintritt in den ersten Pfad ist es dem Netzknoten möglich, die Phasenlage seines eigenen, lokalen Kommunikationszeitplans zu bestimmen. Anhand der Fig. 3 kann dies verdeutlicht werden. Es sind hierbei die Zeitverläufe von zwei Netzknoten K1 und K2 und der im Netzwerk N1 sichtbaren Positionsnachrichten (P3, P5) dargestellt. Der Netzknoten K1 ist dabei von Netzknoten K2 als Referenz-Netzknoten ausgewählt worden. Ein Kommunikationszyklus KS umfasst gemäß dem Kommunikationszeitplan 5 Nachrichtenzeitschlitze NZ und ist in Fig. 3 jeweils durch längere senkrechte Striche angegeben. Die einzelnen Nachrichtenzeitschlitze innerhalb eines Kommunikationszyklus sind durch kürzere senkrechte Striche symbolisiert. Der Netzknoten K1 belegt mit seiner Positionsnachricht P3 den dritten Nachrichtenzeitschlitz. Das aktive Senden dieser Positionsnachricht P3 ist durch ein Rechteck mit einer durchgezogenen Linie dargestellt. Der Netzknoten K2 belegt mit seiner Positionsnachricht P5 den fünften Nachrichtenzeitschlitz. Weitere Netzknoten, welche die übrigen Nachrichtenzeitschlitze im Kommunikationszeitplan belegen, sind hier zur Vereinfachung nicht dargestellt.

Die Information darüber, dass die Positionsnachricht des Netzknotens K1 im dritten Nachrichtenzeitschlitz gesendet wurde, ist der Positionsnachricht selbst zu entnehmen. Damit ist der Netzknoten K2 nach dem Empfang der Positionsnachricht P3 in der Lage, die Phasenlage des Kommunikationszeitplans des Netzknotens K1 zu bestimmen und die Lage seines eigenen Kommunikationszeitplans daran anzupassen. Dies wird im Ablaufdiagramm durch "AnglPh" in Block 8 angegeben. Bei einer statischen Länge der Nachrichtenzeitschlitze und der Kenntnis über den aktuellen Nachrichtenzeitschlitz, kann der Netzknoten K2 die aktuelle Position innerhalb des Kommunikationszyklus berechnen. Damit ist in dem Netzknoten K2 die Phasenlage des Kommunikationszeitplans bekannt. In Fig. 3 ist dieser Zeitpunkt durch das Ereignis E1 gekennzeichnet. Der Netzknoten K2 kennt nach dem Empfang der Positionsnachricht P3 und einer Berechnungsphase, die im Ablaufdiagramm in Fig. 2 in Block 8 durchgeführt wird, die aktuelle Position innerhalb des Kommunikationszyklus. Die Phasenlage seines lokalen Kommunikationszeitplans hat dann der Netzknoten K2 exakt angepasst. Das Rechteck mit der gestrichelten Linie in Fig. 3 symbolisiert die Lage der Positionsnachricht des synchronisierten Netzknotens K2 nach der Phase "AnglPh". Allerdings wird diese Nachricht noch nicht aktiv gesendet. In Fig. 3 ist daher diese Nachricht P5 zu diesem Zeitpunkt auch noch nicht auf dem Netzwerk N1 sichtbar.

Nach Ablauf des aktuellen Kommunikationszyklus geht der Netzknoten K2 in die Phase "Plau" über, die in Fig. 2 durch Block 9 repräsentiert wird. In dieser Phase wird verifiziert, ob eine erfolgreiche Integration des Netzknotens K2 in das Netzwerk N 1 stattgefunden hat. Der Netzknoten K2 kann Nachrichten, die er dann nach der initialen Synchronisation in der Prüfphase "Plau" empfängt, anhand des eigenen Kommunikationszeitplans bewerten. Anhand der eintreffenden Positionsnachrichten überprüft der Netzknoten K2, ob sein Verständnis über die aktuelle Position des Sende-Netzknotens in dem Kommunikationszyklus korrekt ist. Das hierfür verwendete Prüf-Zeitintervall PZ, welches ein Netzknoten K2 zur Prüfung der eigenen Sicht gegenüber der aus den empfangenen Positionsnachrichten abgeleiteten Sicht der anderen Netzknoten nutzt, ist vorab festgelegt. Es umfasst mindestens einen Kommunikationszyklus, damit alle zu der Zeit aktiven Netzknoten in die Prüfung einbezogen werden können. Vorteilhafterweise ist das Prüf-Zeitintervall zum Kommunikationszyklus synchronisiert, d.h., es beginnt mit dem Anfang eines Kommunikationszyklus. Dann ziehen alle Netzknoten, die sich gerade in der Prüfphase des ersten Pfades aufhalten, aber auch Netzknoten, die sich gerade in der weiter unten erläuterten Prüfphase des zweiten Pfades befinden, die gleiche Informationsbasis, d.h., den gleichen Satz an Netzknoten, zur Entscheidungsfindung heran.

Während des Prüf-Zeitintervalls wird jeder Netzknoten, der durch seine Positionsnachricht die Phasenlage seines lokalen Kommunikationszeitplans mitteilt, in eine Kategorie eingeordnet. Entweder deckt sich die lokale Phasenlage des Kommunikationszeitplans im Sende-Netzknoten mit der des integrierenden Netzknotens oder sie stimmt nicht überein. In beiden Fällen wird jeweils ein entsprechender Zähler für die Übereinstimmungen (Z_über) und die Abweichungen (Z_ab) inkrementiert. Bei Beginn des Prüf-Zeitintervalls werden diese Zähler mit 0 initialisiert und am Ende des Prüf-Zeitintervalls ausgewertet. Innerhalb des Prüf-Zeitintervalls wird jeder Netzknoten nur einmal berücksichtigt.

Nach Ende des Prüf-Zeitintervalls PZ (Block 9) wird in Block 10 überprüft, ob eine erfolgreiche Synchronisation des einzubindenden Netzknotens stattgefunden hat. Das wird durch "Sync ?" angegeben. Hierzu können verschiedene Regeln angewendet werden.

Eine erste Regel kann angeben, dass ein Netzknoten nicht synchronisiert ist, wenn am Ende des Prüf-Zeitintervalls der Zählerwert Z_ab größer als Null ist. In diesem Fall gibt es mindestens einen aktiven Netzknoten im Netzwerk, dessen lokaler Kommunikationszeitplan nicht mit dem des prüfenden Netzknotens (und damit auch nicht mit dem vom Referenz-Netzknoten abgearbeiteten Kommunikationszeitplan) synchronisiert ist. Ist der Zählerwert Z_ab gleich null, so muss zum Passieren des Abfrageblocks 10 der Zählerwert Z_über größer oder gleich eins sein, da sonst der Referenz-Netzknoten nicht mehr aktiv ist und dies ebenfalls auf einen Fehler hindeutet. Ist ein Netzknoten so konfiguriert, dass er gemäß dem Kommunikationszeitplan keine Positionsnachricht versendet, so muss Z_über sogar mindestens zwei betragen, da ein solcher Netzknoten nicht in der Lage ist, einen Netzknoten im zweiten Pfad, der gerade allein versucht, die Kommunikation zu starten, in den synchronisierten Normalbetrieb zu überführen. Da ein Netzknoten im zweiten Pfad nur durch Positionsnachrichten erkennt, daß eine Kommunikation zwischen mindestens zwei Netzknoten aufgebaut wurde, kann ein Netzknoten, der keine Positionsnachrichten versendet, lediglich in eine bestehende Kommunikation zwischen mindestens zwei Netzknoten, die Positionsnachrichten versenden, integriert werden.

Eine zweite Regel kann zulassen, dass ein Netzknoten synchronisiert ist, auch wenn fehlerhafte Netzknoten vorhanden sind. Die Verfügbarkeit der Kommunikation ist dann ein Optimierungskriterium, bei dem zum Passieren des Abfrageblocks 10 der Zählerwert Z_ab einen festgelegten Wert nicht überschreiten darf, der Zählerwert Z_über einen festgelegten Wert nicht unterschreiten darf oder aber eine Mehrheit an Übereinstimmungen (Z_über > Z_ab) notwendig ist. Die Mehrheitsentscheidung ist vorteilhaft, da sie unabhängig von der Anzahl der aktiven, zur Entscheidungsfindung herangezogenen Netzknoten eine eindeutige Aussage zulässt. Bei festgelegten Grenzwerten für die Zählerwerte Z_ab oder Z_über muss sonst bei der Beurteilung auch das Verhältnis zu der Anzahl der insgesamt herangezogenen Netzknoten berücksichtigt werden. Auch hier gilt, dass für einen Netzknoten, der gemäß dem Kommunikationszeitplan keine eigene Positionsnachricht versendet, Z_über mindestens zwei betragen muss.

Wird die Prüfphase "Plau" nach Anwendung einer der beiden oben angegebenen Regeln in dem Abfrageblock 10 erfolgreich abgeschlossen, so kann der Netzknoten in den synchronisierten Normalbetrieb übergehen. Damit erlangt der Netzknoten auch die Sendeberechtigung gemäß dem Kommunikationszeitplan.

In Fig. 3 ist die Prüfphase PZ eingezeichnet, die genau die Länge eines Kommunikationszyklus beträgt. Da lediglich der Referenz-Netzknoten K1 in dieser Phase von dem Netzknoten K2 bewertet werden kann, und dieser die Phasenlage des lokalen Kommunikationszeitplans im Netzknoten K2 vorgegeben hat (Netzknoten K1 ist der Referenz-Netzknoten für K2) ist die Prüfung in diesem Beispiel natürlich erfolgreich (Zählerwert Z_über = 1). Mit Beginn des nächsten Kommunikationszyklus kann der Netzknoten K2 aktiv an der Kommunikation teilnehmen (dargestellt durch Kreis 22 in Fig. 2), d.h., er befindet sich im synchronisierten Normalbetrieb. In Fig. 3 ist dies daran erkennbar, dass die Positionsnachricht P5 vom Netzknoten K2 aktiv gesendet wird (Rechteck mit durchgezogener Linie) und daher auf dem Netzwerk N1 erscheint.

Stellt ein Netzknoten im Abfrageblock 10 fest, dass die Bedingung nicht erfüllt ist, geht er zurück zu Block 17 bzw. 18. In diesem Fall steht für den Netzknoten wieder über die Abfrageblöcke 18 und 19 die Entscheidung an, ob er in den ersten oder zweiten Pfad eintritt. Im Gegensatz zu dem Fall, in dem der Netzknoten direkt nach der Freigabe durch die übergeordnete Steuereinheit in Block 17 eintritt, ist nun die Integration, geführt durch einen bestimmten Referenz-Netzknoten, schon mindestens einmal gescheitert. Diese Information wird bei einer Entscheidung für eine passive Integration über den ersten Pfad in dem Abfrageblock 21 ausgewertet. Nach dem Empfang einer Positionsnachricht kann der Netzknoten innerhalb des Blockes 17 den Abfrageblock 18 zum Block 20 verlassen, da eine Positionsnachricht eine Synchronisation des lokalen Kommunikationszeitplans ermöglicht. Aus der Positionsnachricht wird im Block 20 der zugeordnete Netzknoten, der diese Positionsnachricht gesendet hat, bestimmt und als Referenz-Netzknoten gespeichert. Durch die anschließende Abfrage im Abfrageblock 21 muss sichergestellt werden, dass ein Netzknoten nicht dauerhaft und ausschließlich versucht, seinen Kommunikationszeitplan immer wieder zu dem Kommunikationszeitplan desselben Referenz-Netzknoten zu synchronisieren. Ohne einen solchen Mechanismus kann es sonst zu der folgenden, unerwünschten Situation kommen:

Ein sich fehlerhaft verhaltender Netzknoten, dessen Positionsnachricht zwar den Eintritt anderer Netzknoten in den ersten Pfad ermöglicht, aber dessen Kommunikationszeitplan zu dem globalen Kommunikationszeitplan, dem andere, schon aktive Netzknoten folgen, nicht synchronisiert ist, kann jegliche Integration weiterer Netzknoten verhindern. Besetzt dieser Netzknoten den ersten Nachrichtenzeitschlitz eines Kommunikationszyklus, wählen alle Netzknoten, die über den Abfrageblock 10 den ersten Pfad nach einer fehlgeschlagenen Prüfung verlassen, direkt denselben, fehlerhaften Netzknoten wieder für den nächsten Integrationsversuch aus. Ohne Vorkehrungen im vorgeschlagenen Mechanismus würde sich dieser Ablauf so lange wiederholen und die Integration weiterer Netzknoten verhindern, wie der fehlerhafte Netzknoten aktiv bleibt.

Es muss also durch den Abfrageblock 21 sichergestellt werden, dass nach einem gescheiterten Integrationsversuch mindestens einmal ein anderer aktiver Netzknoten (nicht der Netzknoten der zuvor als Referenz-Netzknoten für den gescheiterten Integrationsversuch herangezogen wurde) die Möglichkeit bekonunt, durch einen Netzknoten in dem Block 17 als Referenz-Netzknoten ausgewählt zu werden. Gleichzeitig muss aber auch sichergestellt werden, dass nicht eine kurzzeitige Störung (z.B. eine Übertragungsstörung, die den korrekten Empfang einer Positionsnachricht verhindert) bewirkt, dass ein Netzknoten den ersten Pfad verlassen muss und den aktuellen Referenz-Netzknoten dauerhaft für weitere Integrationsversuche ausschließt. Denn dadurch könnte der Netzknoten dann nicht in den synchronisierten Normalbetrieb übergehen kann, auch wenn sich der ausgeschlossenen Netzknoten nach dem gescheiterten Integrationsversuch fehlerfrei verhält.

Um diese Probleme zu umgehen, werden beispielsweise folgende Methoden verwendet:

Bei einer ersten Methode speichert ein Netzknoten, der aus dem ersten Pfad wieder in Block 17 eintritt, den vormaligen, für den Eintritt in ersten Pfad verwendeten Referenz-Netzknoten als Kref_alt ab. Für die Dauer eines festgelegten Warte-Zeitintervalls wird der Netzknoten Kref_alt nicht als Referenz-Netzknoten akzeptiert, d.h., wenn eine entsprechende Positionsnachricht von diesem Netzknoten empfangen wird, verbleibt der Netzknoten weiterhin in Block 17. Wird während dieses Warte-Zeitintervalls eine Positionsnachricht empfangen, aus der im Block 20 ein neuer Referenz-Netzknoten Kref_neu bestimmt werden kann, wobei Kref_neu nicht gleich Kref_alt ist, so kann der Netzknoten den Abfrageblock 21 in Richtung erstem Pfad (Block 8) verlassen.

Um einen ständigen Wechsel zwischen zwei fehlerhaften Netzknoten zu vermeiden, kann auch eine feste oder zufällige Anzahl von Positionsnachrichten, die während des Aufenthalts in Block 17 empfangen werden, ausgelassen werden, bevor der Abfrageblock 18 wieder in Richtung Block 20 verlassen wird und ein erneuter Eintritt in den ersten Pfad möglich ist. Nach Ablauf des Warte-Zeitintervalls ohne einen erneuten Eintritt in den ersten Pfad, darf auch der bis dahin verbotene Referenz-Netzknoten Kref_alt wieder als neuer Referenz-Netzknoten für einen weiteren Eintritt in den ersten Pfad unter der Voraussetzung benutzt werden, dass eine neue Positionsnachricht von diesem Referenz-Netzknoten Kref_alt empfangen wird und in Block 20 der entsprechende Netzknoten mit Kref_neu = Kref_alt bestimmt wird. Das Warte-Zeitintervall wird mit jedem Übergang von Abfrageblock 10 in den Block 17 neu gestartet. Die Länge des Warte-Zeitintervalls sollte geeigneterweise so gewählt werden, daß die Möglichkeit besteht, dass aus der Menge aller Netzknoten ein aktiver Netzknoten als Referenz-Netzknoten ausgewählt werden kann.

Bei einer zweiten Methode speichert ein Netzknoten, der aus dem ersten Pfad wieder in Block 17 eintritt, ebenso den vormaligen, für den Eintritt in ersten Pfad verwendeten Referenz-Netzknoten als Kref_alt ab. Für die Dauer eines festgelegten Warte-Zeitintervalls wird der Netzknoten Kref_alt nicht als Referenz-Netzknoten akzeptiert, d.h., wenn eine entsprechende Positionsnachricht von diesem Netzknoten empfangen wird, verbleibt der Netzknoten weiterhin in Block 17. Während dieses Warte-Zeitintervalls entscheidet der Netzknoten anhand einer gespeicherten Datenbasis, welchen Netzknoten als Referenz-Netzknoten für einen weiteren Integrationsversuch herangezogen wird. Der Abfrageblock 21 wird also nur dann in Richtung erstem Pfad verlassen, wenn der in Block 20 bestimmte Referenz-Netzknoten Kref_neu in der Datenbasis vermerkt ist. Diese Datenbasis und die damit verbundene Reihenfolge, in der Netzknoten als Referenz-Netzknoten verwendet werden, kann statisch konfiguriert sein oder aber dynamisch, während der Phase erzeugt werden, in der ein Netzknoten im ersten Pfad verweilt. Die dynamisch erzeugte Datenbasis muss dann für jede Positionsnachricht einen Eintrag enthalten, die während des Aufenthalts des Netzknotens in den Blöcken 8 und 9 empfangen wurden.

Auch bei dieser zweiten Methode ist es möglich, dass nach Ablauf des Warte-Zeitintervalls ohne einen erneuten Eintritt in den ersten Pfad, auch der bis dahin verbotene Referenz-Netzknoten Kref_alt wieder als neuer Referenz-Netzknoten für einen weiteren Eintritt in den ersten Pfad unter der oben genannten Voraussetzung verwendet werden darf.

Mit Hilfe der Datenbasis können auch kompliziertere Algorithmen umgesetzt werden, die eine längere Überwachung des bisherigen Verlaufs für die Integration eines Netzknotens zulassen. Beispielsweise können alle Netzknoten, die als Referenz-Netzknoten für einen gescheiterten Integrationsversuch herangezogen worden sind, solange als Referenz-Netzknoten gesperrt bleiben, bis alle Netzknoten, die in der Datenbasis gespeichert sind, einmal als Referenz-Netzknoten benutzt worden sind.

Zusätzlich kann ein weiteres Warte-Zeitintervall definiert werden, welches mit dem ersten Scheitern eines Integrationsversuches gestartet wird und nach dessen Ablauf wieder alle Netzknoten als Referenz-Netzknoten herangezogen werden können. Dies bewirkt, dass wieder alle Netzknoten als potentielle Referenz-Netzknoten zur Verfügung stehen, wenn durch das Auswahlverfahren für einen Referenz-Netzknoten anhand der beschriebenen Datenbasis keine Integration erreicht werden konnte.

Im folgenden wird beschrieben, was geschieht, wenn ein Netzknoten die Abfrage im Abfrageblock 19 bejaht und in den zweiten Pfad eintritt. Hier versucht er dann selbst aktiv die Kommunikation aufzubauen. In einem ersten Schritt muss die Situation aufgelöst werden, dass mehr als ein Netzknoten in den zweiten Pfad eintritt.

Ohne das Senden eines Kollisionssymbols KO kann die in Fig. 4 dargestellte Situation auftreten. Der Netzknoten K2 betritt den zweiten Pfad bei Ereignis E2 und der Netzknoten K1 zeitlich versetzt bei Ereignis E3 (zwei Nachrichtenzeitschlitze später). Die Ereignisse E2 und E3 werden nach Ablauf der Abfragen in den Abfrageblöcken 18 und 19 in Block 17 ausgelöst. Beide Netzknoten K1 und K2 starten lokal Ihren Kommunikationszyklus und senden gemäß dem Kommunikationszeitplan ihre Positionsnachrichten. Der Netzknoten K1 sendet die Positionsnachricht P3 und der Netzknoten K2 sendet zeitgleich die Positionsnachricht P5. Beide Nachrichten kollidieren auf dem Netzwerk N1 und sind daher für andere Netzknoten nicht korrekt zu empfangen. Ist für die sendenden Netzknoten K1 und K2 die Kollision nicht erkennbar, wie es z.B. für optische Übertragungsmedien der Fall ist, so werden beide Netzknoten dauerhaft versuchen eine Kommunikation aufzubauen. Da die anderen Netzknoten jedoch keine korrekte Positionsnachricht empfangen können, auf der anderen Seite aber ständige Netzwerkaktivität den Eintritt eines weiteren Netzknotens in den zweiten Pfad verhindert, wird dauerhaft eine Kommunikation zwischen den Netzknoten des Netzwerks verhindert.

Daher beginnt der zweite Pfad im Ablaufdiagramm mit der Angabe, dass zuerst ein Kollisionssymbol KO ausgesendet wird (Block 11). Anschließend wird der Kommunikationszeitplan periodisch abgearbeitet. Das Kollisionssymbol KO ist kein Element des Kommunikationszeitplans. Das Kollisionssymbol KO kann eine beliebige Ausprägung haben, allerdings darf es sich nicht um eine gültige Positionsnachricht handeln.

Aus Fig. 5 wird deutlich, welcher Effekt die Einführung des Kollisionssymbols KO für die Auflösung einer Situation mit mehr als einem Netzknoten im zweiten Pfad hat. Dadurch, dass jeder Netzknoten vor der Abarbeitung seines lokalen Kommunikationszeitplans dieses Kollisionssymbol KO schickt, besteht zwischen dem Kollisionssymbol KO und der eigenen Positionsnachricht gemäß dem Kommunikationszeitplan eine im Netzwerk einmalige Zeitspanne. Das bedeutet, dass Netzknoten, die zur selben Zeit in den zweiten Pfad eintreten und ein Kollisionssymbol KO senden, in dem darauffolgenden jeweiligen Kommunikationszyklus in jedem Fall zu unterschiedlichen Zeiten ihre Positionsnachricht absetzen. Die Positionsnachrichten von verschiedenen Netzknoten können dann nicht mehr kollidieren. Einem Netzknoten wird es dadurch möglich eine Positionsnachricht zu empfangen, die vor der eigenen Positionsnachricht im Kommunikationszeitplan liegt und auf dem Netzwerk beobachtbar ist. Daraufhin verlässt dieser Netzknoten den zweiten Pfad und kehrt wieder nach Block 17 zurück. Es verbleibt lediglich der Netzknoten im zweiten Pfad, der als erstes seine Positionsnachricht gesendet hat.

Aus Fig. 5 wird deutlich, dass die Netzknoten K1 und K2 jeweils gleichzeitig in den zweiten Pfad eintreten, nachdem zur selben Zeit die Beobachtungs-Zeitintervalle im Block 17 abgelaufen sind (Ereignis E4 und E5). Sowohl der Netzknoten K1 als auch der Netzknoten K2 senden ihr jeweiliges Kollisionssymbol KO. Danach starten beide Netzknoten mit der Abarbeitung ihres lokalen Kommunikationszeitplans. Durch das Kollisionssymbol KO sind beide Netzknoten innerhalb des zweiten Pfads zeitlich synchronisiert. Ein zeitlicher Versatz zwischen zwei Netzknoten im zweiten Pfad, wie er in Fig. 4 dargestellt und in einem System ohne Kollisionssymbol KO möglich wäre, kann nicht mehr auftreten. Sobald ein Netzknoten früher als ein anderer Netzknoten in den zweiten Pfad eintritt, verhindert er den Eintritt weiterer Netzknoten in den zweiten Pfad durch das Senden des Kollisionssymbols KO, welches bei den übrigen Netzknoten im Block 17 einen Neustart des Beobachtungs-Zeitintervalls bewirkt.

Gemäß dem Kommunikationszeitplan sendet der Netzknoten K1 als erstes seine Positionsnachricht P3 (vgl. Fig. 5). Das wird im Ablaufdiagramm in Block 12 durch "SendPos" dargestellt. Die Positionsnachricht P5 des Netzknotens K2 liegt im Kommunikationszeitplan zeitlich später. Der Netzknoten K2 sendet aber seine Positionsnachricht P5 gar nicht mehr, da er die Positionsnachricht P3 von Netzknoten K1 empfängt (Ereignis E6). Die Prüfung, ob ein anderer Netzknoten schon eine Positionsnachricht gesendet hat, wird im Ablaufdiagramm der Fig. 2 im Block 13 durch "CheckAct" dargestellt. Hat ein Netzknoten (hier Netzknoten K2) eine Positionsnachricht festgestellt, verlässt er den zweiten Pfad und geht von Block 13 zum Block 17, um ein neues Beobachtungs-Zeitintervall zu starten. In Fig. 5 ist weiterhin dargestellt, dass der Netzknoten K2 dann mit dem Empfang der nächsten Positionsnachricht P3 in den ersten Pfad eintritt (Ereignis E7). Dabei werden die Abfrageblöcke 18 und 21 passiert und vom Netzknoten K2 der Netzknoten K1 als Referenz-Netzknoten ausgewählt. Durch die verfügbare Positionsinformation P3 kann der Netzknoten K2 die Phasenlage seines lokalen Kommunikationszeitplans entsprechend anpassen. Nachfolgend durchläuft der Netzknoten K2 die Prüfphase "Plau" in Block 9, die er erfolgreich abschließt, da der Referenz-Netzknoten K1 als einziger Netzknoten zur Prüfung herangezogen wird, und die Phasenlage des lokalen Kommunikationszeitplans des Netzknotens K2 bestätigt (K_über = 1, K_ab = 0) wird. Mit Beginn des nächsten Kommunikationszyklus geht der Netzknoten K2 in den synchronisierten Normalbetrieb über (Ereignis E8).

In der Phase in Block 14 sendet ein Netzknoten gemäß dem Kommunikationszeitplan seine Positionsnachricht (Block 12, Phase "SendPos"). In der übrigen Zeit, d.h., wenn der Netzknoten nicht aktiv sendet, prüft er, ob auf dem Verbindungs-Netzwerk Sendeaktivität eines anderen Netzknotens empfangen werden kann (Block 13, Phase "CheckAct"). Der Netzknoten verbleibt für eine festgelegte Anzahl von Kommunikationszyklen in der Phase in Block14, dabei stehen die Phasen "SendPos" und "CheckAct" nicht zeitlich sequentiell hintereinander, sondern werden gemäß dem Kommunikationszeitplan durchlaufen.

Auch für die Prüfung "CheckAct" in Block 13, ob ein Empfangsereignis aufgetreten ist, welche den Übergang zu Block 17 bewirkt, können verschiedene die Entscheidung beeinflussende Regeln definiert werden.

Für ein Netzwerk, welches nicht auf fehlerhaft agierende Netzknoten oder gestörte Nachrichten reagiert oder das Auftreten von Fehlern toleriert, kann folgende Regel definiert werden:

Jede korrekte Positionsnachricht wird als Empfangsereignis in Block 13 gewertet und bewirkt, daß ein Netzknoten daraufhin in Block 17 zurückkehrt. Dadurch wird sichergestellt, dass nur ein Netzknoten im zweiten Pfad verbleibt.

Für ein Netzwerk, welches fehlerhaft agierende Netzknoten oder gestörte Nachrichten toleriert, d.h. in vorhersagbarer Weise auf deren Verhalten reagieren muss, kann folgende Regel definiert werden:

Jede korrekte Positionsnachricht, aber auch ein Kollisionssymbol oder eine gestörte Nachricht (z.B. durch einen erkannten Fehler im Code-Sicherungsverfahren, wie z.B. einer CRC Prüfsumme, detektierbar) wird als Empfangsereignis in Block 13 gewertet. Diese Regel kann auch noch weiter gefasst werden, so dass der Empfang eines bestimmten Teilmerkmals einer Nachricht oder sogar jede Art von Netzwerkaktivität, die ein eventuell vorhandenen Störfilter im Empfangspfad übenvindet, als Empfangsereignis in Block 13 gewertet wird. Je weniger spezifisch das Empfangsereignis für ein Netzwerk definiert wird, desto empfindlicher reagiert ein Netzknoten im zweiten Pfad auf Störungen und auf sich fehlerhaft verhaltende Netzknoten. Der Netzknoten im zweiten Pfad geht dann in die Ausgangsphase in Block 17 zurück und beobachtet das weitere Kommunikationsgeschehen, d.h. startet erneut sein Beobachtungs-Zeitintervall.

Die vorgegebene Anzahl von Kommunikationszyklen, in denen ein Netzknoten in Block 14 verweilt, hängt von der Dauer der Phasen der Blöcke 8 und 9 ab. Es muss verhindert werden, dass ein Netzknoten im ersten Pfad den Abfrageblock 10 erfolgreich passiert, während der Referenz-Netzknoten durch eine geringe Störung in der Phase im Block 14 wieder zurück zum Block 17 geht. Eine Bedingung für die Dimensionierung der Zeitintervalle einerseits in dem Block 14 und andererseits in den Blöcken 8 und 9 zueinander ergibt sich daher wie folgt:

Der Netzknoten im zweiten Pfad darf sich nicht mehr in Block 14 befinden, sondern muss schon in Block 15 sein, wenn ein Netzknoten im ersten Pfad sein Prüf-Zeitintervall abarbeitet, an dessen Ende über den Abfrageblock 10 der Eintritt in den synchronisierten Normalbetrieb möglich ist.

Für das in Fig. 2 angegebene Ablaufdiagramm ist für die Abarbeitung in Block 14 ein Kommunikationszyklus ausreichend, wenn die Abarbeitung in Block 8 innerhalb des Kommunikationszyklus, in der die Positionsnachricht zur Referenzbestimmung empfangen wurde, abgeschlossen wird und das Prüf-Zeitintervall (Block 9) mit dem nächsten Kommunikationszyklus beginnt. Innerhalb dieses einen Kommunikationszyklus im Block 14 wird der parallele Eintritt von mehr als einem Netzknoten in den zweiten Pfad ebenfalls aufgelöst. Dauert die Phase des Blocks 8 länger, so wird auch die Länge der Phase in Block 14 für das Netzwerk angepasst (verlängert). Wichtig ist, dass sich ein Netzknoten im zweiten Pfad so lange wie möglich in der Phase des Blockes 14 befindet, um auf alle möglichen Fehler reagieren zu können (Block 13).

Hat der Netzknoten im zweiten Pfad die vorgegebene Anzahl an Kommunikationszyklen in Block 14 verbracht, und wurde er nicht durch ein Empfangsereignis in Block 17 zurückversetzt, so geht er zu Block 15 über. Auch während sich der Netzknoten in der Phase des Blocks 15 befindet, sendet er weiterhin gemäß dem Kommunikationszeitplan seine Positionsnachricht. Zusätzlich verifiziert der Netzknoten in Block 15 ("Verif"), ob er erfolgreich eine Kommunikation zu mindestens einem weiteren Netzknoten aufgebaut hat. Genauso wie bei Block 9 kann ein Netzknoten Positionsnachrichten anhand des eigenen Kommunikationszeitplans bewerten. Eintreffende Positionsnachrichten können daraufhin überprüft werden, ob die enthaltene Positionsinformation, die eine Aussage über die aktuelle Position des Sende-Netzknotens innerhalb des Kommunikationszyklus beinhaltet, mit dem lokalen Verständnis übereinstimmt. Ein Verifikations-Zeitintervall, welches der Netzknoten im zweiten Pfad in Block 15 zur Verifikation der eigenen Sicht gegenüber der aus den empfangenen Positionsnachrichten abgeleiteten Sicht der anderen Netzknoten nutzt, ist vorab festgelegt. Es umfasst mindestens einen Kommunikationszyklus, damit alle Netzknoten in die Prüfung einbezogen werden können. Vorteilhafterweise ist das Verifikations-Zeitintervall zum Kommunikationszyklus synchronisiert, d.h. es beginnt mit dem Anfang eine Kommunikationszyklus. Anders als in der Prüfphase im Block 9, wird das Verifikations-Zeitintervall zyklisch wiederholt, solange keine Positionsnachricht im Verifikations-Zeitintervall empfangen worden ist (Prüfphase in Block 15). Diese Situation entsteht z.B. dann, wenn ein Netzknoten früher als die anderen Netzknoten des Netzwerks die Freigabe durch die übergeordnete Steuereinheit erhält. Dann durchläuft dieser Netzknoten die Blöcke 17, 11 und 14 und tritt in den Block 15 ein, ohne dass schon ein anderer Netzknoten überhaupt auf die Vorgabe des Kommunikationszeitplans reagieren, d.h. sich dazu synchronisieren kann. Ein Netzknoten kann also für eine längere Zeit in Block 15 verweilen, und darauf warten, dass ihn ein oder mehrere Netzknoten als Referenz-Netzknoten auswählen, über den ersten Pfad in den synchronisierten Normalbetrieb übergehen, und dann aktiv eine Positionsnachricht senden, die der Netzknoten in Block 15 empfangen kann. Wird ein Verifikations-Zeitintervall abgeschlossen, ohne dass eine Positionsnachricht empfangen wurde, so wird ein neues Verifikations-Zeitintervall in Block 15 gestartet und noch keine Bewertung und Abfrage in dem nachfolgenden Abfrageblock 16 vollzogen.

Während des Verifikations-Zeitintervalls wird jeder Netzknoten, der durch seine Positionsnachricht die Phasenlage seines lokalen Kommunikationszeitplans mitteilt, in eine Kategorie eingeordnet. Entweder die lokale Phasenlage des Kommunikationszeitplans im Sende-Netzknotens deckt sich mit der des vorgebenden Netzknotens im zweiten Pfad oder sie stimmt nicht überein. In beiden Fällen wird ein jeweils entsprechender Zähler für die Übereinstimmungen (Z_über) und die Abweichungen (Z_ab) inkrementiert und am Ende des Verifikations-Zeitintervalls ausgewertet. Innerhalb des Verifikations-Zeitintervalls wird jeder Netzknoten nur einmal berücksichtigt. Der Abfrageblock 16 wird nur dann erfolgreich passiert, wenn die Mehrheit der aktiven Netzknoten ihre lokalen Kommunikationszeitpläne zueinander synchronisiert abarbeiten, d.h. Z_über größer als Z_ab ist.

Der Netzknoten, der sich in dem Block 15 befindet, wird als Vorgabe-Netzknoten bezeichnet. Dieser Vorgabe-Netzknoten muss bei Block 15 berücksichtigen, dass er selbst aktiv Positionsnachrichten versendet. Daher muss er sich selbst als synchronisierten Netzknoten bei der Entscheidungsfindung in dem Abfrageblock 16 berücksichtigen. Dies kann durch eine Vorinitialisierung des Zählers Z_über mit dem Zählerwert eins geschehen oder aber durch Anpassung der Abfrage im Abfrageblock 16 abgedeckt werden. Der Übergang in den synchronisierten Normalbetrieb findet dann statt, wenn Z_über größer oder gleich Z_ab ist. Dadurch, dass sich der Vorgabe-Netzknoten selbst bei der Verifikation einer synchronisierten Kommunikation mitzählt, kann eine kritische Situation mit nur 2 weiteren Netzknoten, von denen einer fehlerhaft arbeitet, verhindert werden. Würde der Vorgabe-Netzknoten nicht mitgezählt, würde in dem Fall mit einem korrekt arbeitenden Netzknoten und einem zweiten fehlerhaft arbeitenden Netzknoten, der Vorgabe-Netzknoten zu Block 17 zurückkehren. Solange dann die verbleibenden zwei Netzknoten mit nicht übereinstimmender Phasenlage des Kommunikationszeitplans ihre Positionsnachrichten senden, kann kein weiterer Netzknoten synchronisiert werden, da diese Konstellation immer zu einem Abbruch im Block 9 und 10 des ersten Pfads führt.

Da der Vorgabe-Netzknoten im zweiten Pfad aktiv seine Positionsnachricht versendet, kann er davon ausgehen, dass Netzknoten im ersten Pfad ihn als Referenz-Netzknoten herangezogen haben und diese Nachricht zur Prüfung in Block 9 verwenden. Im fehlerfreien Fall werden dann während des Verifikations-Zeitintervalls nur Positionsnachrichten empfangen, die den Referenz-Netzknoten im zweiten Pfad bestätigen.

Kann ein Netzknoten die Abfrage "SyncNK ?" im Abfrageblock 16 erfolgreich passieren, so tritt er in den synchronisierten Normalbetrieb ein. Hat ein Netzknoten während eines Verifikations-Zeitintervalls mindestens eine Positionsnachricht empfangen und steht daher die Entscheidung im Abfrageblock 16 an, so muss er zum Block 17 zurückkehren, falls er abgewiesen wird. Wird der Zählerwert Z_über zu Beginn der Verifikations-Zeitintervall mit dem Wert eins initialisiert, so wird der Netzknoten im Abfrageblock 16 abgewiesen, wenn der Zählerwert Z_ab größer oder gleich dem Zählerwert Z_über ist.

In einem stark gestörten Umfeld (z.B. Einstrahlung auf das Netzwerk) kann es passieren, dass ein Netzknoten den Block 17 nicht verlassen kann, da weder korrekte Positionsnachrichten empfangen werden, noch das Beobachtungs-Zeitintervall abläuft, welches für eine festgelegte Dauer Ruhe im Netzwerk signalisiert. Soll ein Netzwerk aber auch in diesem Fall synchronisiert werden, so muss für die Netzknoten eine Rückfallebene definiert werden, die es einem Netzknoten erlaubt, in einem solchen Fall trotzdem in den zweiten Pfad einzutreten. Dazu wird ein Zeitfenster-Zähler mit dem Eintritt in Block 17 gestartet, welcher auch dann nicht neu gestartet wird, sobald Netzwerkaktivität vom Netzknoten empfangen wird. Dieses Zeitfenster ist größer als das reguläre Beobachtungs-Zeitintervall. Läuft dieses Zeitfenster ab, so geht ein Netzknoten in den zweiten Pfad zu Block 11 und versucht eine Kommunikation aufzubauen. Verlässt ein Netzknoten vor Ablauf dieses Zeitfensters den Block 17, so wird der Zeitfenster-Zähler gestoppt. Scheitert der Netzknoten dann im ersten oder zweiten Pfad, so kann der Zeitfenster-Zähler entweder zurückgesetzt werden oder aber ab dem gespeicherten Stand vor Eintritt in den ersten oder zweiten Pfad weiterlaufen. Die Auswahl einer dieser Alternativen führt zu unterschiedlichen Strategien für die Rückfallebene, die sich im wesentlichen in der Zeit unterscheiden, nach der ein Netzknoten aufgrund des abgelaufenen Zeitfensters in den zweiten Pfad eintritt.

Ein Netzknoten, der über eine gestörte, hier nicht dargestellte Empfangsschaltung verfügt, kann zwar noch Nachrichten senden, aber nicht empfangen. Ein solcher Netzknoten wird den zweiten Pfad betreten, da innerhalb des Beobachtungs-Zeitintervalls in Block 17 keine Netzwerkaktivität erkennbar ist (auch wenn sich schon längst andere Netzknoten z.B. im synchronisierten Normalbetrieb befinden). Er wird sich dann für immer im Block 15 aufhalten, da der Abfrageblock 16 den Netzknoten nicht in den synchronisierten Normalbetrieb übergehen lässt. Trotzdem sendet der Netzknoten dauerhaft seine Positionsnachricht und stört damit die eventuell parallel laufende Kommunikation anderer Netzknoten. Als Abhilfe kann hier eine weitere Rückfallebene definiert werden, die nach Ablauf einer festgelegten Zeit, in welcher der Netzknoten über den zweiten Pfad sich nicht synchronisieren kann, dafür sorgt, dass ein Netzknoten die Berechtigung für den Eintritt in den zweiten Pfad verliert. Dazu kann beispielsweise ein Zähler definiert werden, der die Anzahl der Kommunikationszyklen zählt, in denen sich der Netzknoten im zweiten Pfad aufgehalten hat. Erreicht der Zähler einen festgelegten Grenzwert, so kann der Netzknoten den Abfrageblock 19 nicht mehr in Richtung Block 11 passieren. Lediglich die passive Integration über den ersten Pfad ist dann für diesen Netzknoten noch möglich. Dieser Zustand kann lediglich durch die übergeordnete Steuereinheit aufgehoben werden.

Es kann auch eine zusätzliche Regel für den Abfrageblock 19 vorgeschrieben werden, die besagt, daß ein Netzknoten nur dann in den zweiten Pfad eintreten kann, wenn er dazu durch die übergeordnete Steuereinheit eine spezielle Freigabe erteilt. In diesem Fall kann ein Netzknoten solange nicht aktiv versuchen, eine Kommunikation aufzubauen, bis die übergeordnete Steuereinheit dies explizit zulässt. In dieser Phase kann der Netzknoten jedoch über den ersten Pfad in eine laufende Kommunikation integriert werden. Dadurch hat die übergeordnete Steuereinheit in einem Netzknoten die Kontrolle darüber, in welcher Rolle, d.h., über welchen Pfad der Netzknoten in die Kommunikation einsteigt.
Wird einem Netzknoten durch die übergeordnete Steuereinheit im Netzknoten allgemein die Sendeberechtigung vorenthalten, so kann auch dann der Netzknoten nicht in den zweiten Pfad eintreten, jedoch über den ersten Pfad sich zu einem vorgegebenen Kommunikationszeitplan synchronisieren. Das Vorenthalten der Sendeberechtigung kann z.B. dann vorteilhaft sein, wenn zur Diagnose lediglich die Kommunikation überwacht werden soll, ohne aktiv daran teilzunehmen. Für den Übergang in den synchronisierten Normalbetrieb, wobei sich der Netzknoten auch dann noch weiter passiv verhält, gelten dann die gleichen Regeln bei dem Abfrageblock 10, wie für Netzknoten, die keine eigene Positionsnachricht verschicken.

Die Synchronisation der Phasenlagen der lokalen Kommunikationszeitpläne innerhalb der Netzknoten ist die notwendige Voraussetzung, damit überhaupt das Medienzugriffsverfahren im Normalbetrieb und damit der deterministische Datenaustausch mittels des Verbindungs-Netzwerks möglich ist. Darüber hinaus können aber auch weitere Parameter lokal in einem Netzknoten verwaltet werden, die zu einer globalen Übereinstimmung gebracht werden müssen. Ein Beispiel ist ein Zykluszähler für die Kommunikationszyklen, der lokal in den jeweiligen Netzknoten verwaltet wird. Wird dessen aktueller Zählerstand mit einer Nachricht versendet, so kann der Zählerstand beim Empfänger zur Validierung der mitübertragenen Daten herangezogen werden, indem der übertragene Zählerstand gegen den lokalen Zählerstand verglichen wird. Außerdem kann z.B. die Messphase der globalen Uhrensynchronisation anhand des lokalen Zählerstands eines Zyklenzählers im jeweiligen Netzknoten Netzwerk-weit synchronisiert werden.

Des weiteren kann ein solcher Zykluszähler dazu verwendet werden, die Datenfelder innerhalb einer Nachricht abhängig vom aktuellen Zykluszählerstand mit verschiedenen Inhalten zu füllen. Diese Entscheidung wird dann beim Empfänger anhand des eigenen Zykluszählers, der zu dem des Senders synchronisiert ist, nachvollziehbar, ohne dass eine Information über den Inhalt mit übertragen werden muss. Für solche Parameter, wie den beschriebenen Zykluszähler, kann dasselbe Verfahren venvendet werden, wie es für die Synchronisation der Phasenlagen der Kommunikationszeitpläne beschrieben wurde. Dadurch kann ein Netzknoten im zweiten Pfad seinen Parametersatz (z.B. den Zählerstand des Zykluszählers) an alle Netzknoten verteilen, die diesen dann zur Initialisierung ihrer lokalen Parametersätze (z.B. Zykluszähler) verwenden. Die Mechanismen zur Prüfung finden auch hier analog ihre Anwendung. Beispielsweise kann die bislang beschriebene Positionsnachricht auch noch weitere Parameter enthalten, und in den Phasen des Blocks 9 und des Blocks 15 werden nur dann die Zähler für eine Übereinstimmung (Z_über) inkrementiert, wenn alle zu synchronisierenden Parameter übereinstimmen. Bei einer oder mehreren Abweichungen innerhalb des Parametersatzes wird dann der entsprechende Zähler (Z_ab) inkrementiert.

Bei Netzwerken, in denen jeder Netzknoten mit einer eigenen Taktquelle versorgt wird, sind in der Praxis immer Unterschiede in den Taktfrequenzen zu beobachten, auch wenn alle Taktquellen mit der selben Nominalfrequenz arbeiten. In Abhängigkeit von der verwendeten Taktquelle sind anfängliche Toleranzen in der tatsächlichen Frequenz und weitere Frequenzänderungen z.B. durch Alterung nicht zu vermeiden.

Während des synchronisierten Normalbetriebs wird durch die weiter vorne beschriebene globale Uhrensynchronisation sichergestellt, dass die zeitliche Lage und die Länge der Kommunikationszeitpläne aller Netzknoten im Rahmen der für das Netzwerk spezifischen Auflösung bzw. Genauigkeit übereinstimmen. Ein Netzknoten kann nur dann eine Synchronisation durch Anpassung der Phase seines Kommunikationszeitplans ausführen, wenn die Frequenzunterschiede bzw. Ungenauigkeiten der lokalen Taktquellen gering sind. Es muss nämlich sichergestellt werden, dass zwischen den Phasen der Blöcke 8 und 9 bzw. 14 und 15 keine Verschiebung der Kommunikationszeitpläne gegeneinander erfolgt. Die Maßnahmen zur Synchronisation im laufenden Betrieb brauchen dann erst mit Eintritt in den synchronisierten Normalbetrieb gestartet werden.

Für Netzwerke, bei denen z.B. aus Kostengründen Taktquellen mit großen Toleranzen eingesetzt werden, oder bei denen aufgrund der langen Lebensdauer mit hohen Abweichungen von der Nominalfrequenz gerechnet werden muss, kann die oben genannte Annahme nicht garantiert werden. In diesem Fall ergäbe sich zwischen den Phasen der Blöcke 8 und 9 bzw. 14 und 15 eine Verschiebung der Kommunikationszeitpläne, die eine Synchronisierung nicht ermöglicht

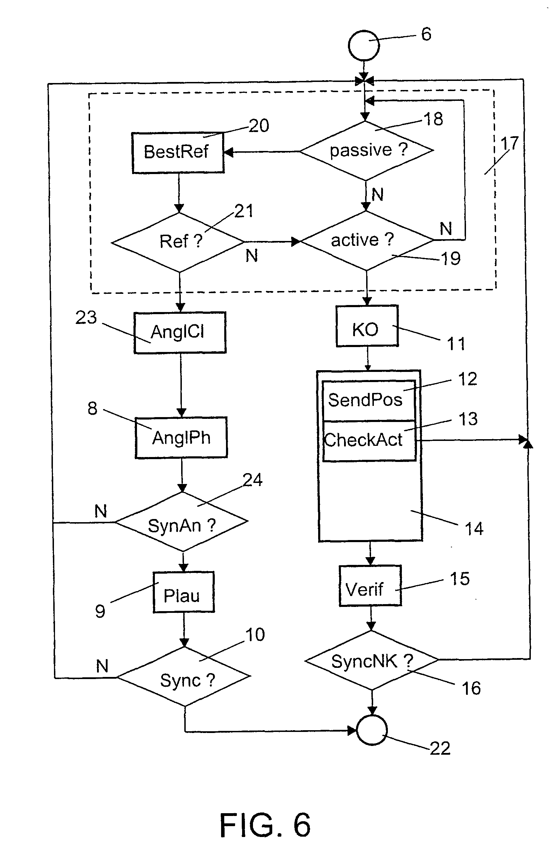

Um dieses Problem zu lösen, wird erfindungsgemäß das in Fig. 2 dargestellte Ablaufdiagramm durch weitere Blöcke ergänzt, so dass sich ein erweitertes Ablaufdiagramm in Fig. 6 ergibt. Der erste Pfad ist durch einen Block 23 zwischen dem Abfrageblock 21 und Block 8 und durch einen Abfrageblock 24 zwischen den Blöcken 8 und 9 ergänzt.

Der Block 23 führt eine Angleichung des lokalen Uhrentaktes des sich einbindenden Netzknotens an den des Referenz-Netzknotens durch. Dabei wird in dem Netzknoten mit dem ersten Auftreten der Positionsnachricht des Referenz-Netzknotens eine Messphase gestartet, die mit dem zweiten Auftreten der Positionsnachricht des Referenz-Netzknotens gestoppt wird. Damit ist die Dauer des Kommunikationszyklus des Referenz-Netzknotens für den Netzknoten im ersten Pfad bekannt. Anschließend wird der lokale Uhrentakt des Netzknotens und dementsprechend die Dauer seines lokalen Kommunikationszyklus an den Uhrentakt des Referenz-Netzknotens angeglichen. Diese Phase wird im Block 23 mit "AnglCl" dargestellt. Danach arbeitet der Netzknoten (z.B. in der Phase "AnglPh") mit dem angepassten Uhrentakt.

Nachdem der lokale Uhrentakt angepasst worden ist, wird erst mit der zweiten Positionsnachricht des Referenz-Netzknotens die Angleichung der Phasenlage des lokalen Kommunikationszeitplans zu der Phasenlage des Kommunikationszeitplans des Referenz-Netzknotens vorgenommen (in Block 8). Falls die zweite Positionsnachricht nach Ablauf eines Halte-Zeitintervalls nicht aufgetreten ist, geht der Netzknoten in die Ausgangsphase, nämlich zu Block 17 zurück. Diese Abfrage wird im Abfrageblock 24 durchgeführt und als "SynAn ?" bezeichnet. Die Dauer dieses Halte-Zeitintervalls muss mindestens gleich der Dauer eines Kommunikationszyklus und dem maximal möglichen Versatz zwischen den Phasenlagen der lokalen Kommunikationszyklen von zwei nicht synchronisierten Netzknoten sein. Wenn der Netzknoten in die Ausgangsphase zurückkehrt, wird der lokale Uhrentakt des Netzknotens wieder auf die Nominaleinstellung zurückgesetzt. Das bedeutet, dass die Korrektur zur Angleichung des Uhrentaktes an den Referenz-Netzknoten wieder rückgängig gemacht werden.

Die bisher beschriebenen Maßnahmen können so erweitert werden, dass ein Netzknoten in dem ersten Pfad des Ablaufdiagramms während der Prüfphase in Block 9 schon die Maßnahmen zur fehlertoleranten, globalen Uhrensynchronisation ausführt, die weiter vorne beschrieben sind. Ein Netzknoten wertet dazu die Synchronisationsinformation aller empfangenen Positionsnachrichten aus, d.h. dieser bestimmt die Abweichung in der Phasenlage zwischen den lokalen Kommunikationszeitplänen der sendenden Netzknoten und des eigenen Kommunikationszeitplans während der Prüfphase in Block 9. Ein Netzknoten im ersten Pfad kann nur dann in den synchronisierten Normalbetrieb übergehen, wenn das Verfahren zur globalen, fehlertoleranten Uhrensynchronisation, das auf den während der Prüfphase in Block 9 empfangenden Positionsnachrichten basiert, signalisiert, dass eine Synchronisation im Rahmen der erzielbaren Genauigkeit erreicht wurde. Wurden Korrekturterme ermittelt, die anzeigen, dass der Netzknoten außerhalb der zulässigen, zeitlichen Abweichung liegt, muß der Netzknoten beim Abfrageblock 10 abgewiesen werden.

Die globale Uhrensynchronisation basiert auf einem Raster, bestehend aus der Messphase zu einer Korrekturtermbestimmung und der Korrekturphase zur Angleichung der lokalen Phasenlage des Kommunikationszeitplans sowie eventuell zur Angleichung des lokalen Uhrentaktes. Werden z.B. zwei aufeinanderfolgende Kommunikationszyklen für die Messphase benötigt, um einen Korrekturterm für den lokalen Uhrentakt bestimmen zu können, und darf die Korrekturphase zur Angleichung der Phasenlage des Kommunikationszeitplans die Messphase nicht stören, so müssen alle Netzknoten eines Netzwerks einheitlich das gleiche, synchronisierte Ablaufschema bestehend aus Mess- und Korrekturphase verfolgen. Diese Periode, z.B. bestehend aus zwei Kommunikationszyklen, muss in allen Netzknoten immer zu einem Raster synchronisiert werden, welches dann auf dem Zykluszähler abgestützt werden kann. Beispielsweise kann dieses Raster immer mit einem Kommunikationszyklus mit einem geraden Zählerstand beginnen. Dann kann ein sich in Block 17 befindlicher Netzknoten auch nur dann in den ersten Pfad eintreten, wenn er eine Positionsnachricht mit einem Zählerstand empfängt, der eine Synchronisation zu dem Raster sicherstellt. Die Abweisung kann dann durch den Abfrageblock 21 sichergestellt werden. Vor dem Eintritt in die Prüfphase in Block 8 setzt ein Netzknoten seinen lokalen Zykluszähler auf den Wert, den er aus der empfangenen Positionsnachricht des Referenz-Netzknotens entnehmen kann. Mit Hilfe des Zykluszählers synchronisiert sich der Netzknoten auf ein Raster, welches im gesamten Netzwerk einheitlich abgearbeitet werden muß. Daher muß dann auch der Wert des Zykluszählers innerhalb der Prüfphase in Block 9 mit denen der anderen aktiven Netzknoten verglichen werden. Eine Übereinstimmung ist für den Übergang in den synchronisierten Normalbetrieb eine notwendige Voraussetzung, die zusätzlich durch Abfrageblock 10 sichergestellt werden muss.

Ebenso kann ein Netzknoten im zweiten Pfad während der Prüfphase in Block 15 ebenfalls die Maßnahmen zur fehlertoleranten, globalen Uhrensynchronisation ausführen. Ein Netzknoten im zweiten Pfad kann nur dann in den synchronisierten Normalbetrieb übergehen, wenn die Verfahren zur Uhrensynchronisation basierend auf den Positionsnachrichten, die während der Prüfphase in Block 9 empfangen werden konnten, signalisieren, dass eine Synchronisation im Rahmen der erzielbaren Genauigkeit erreicht wurde. Ansonsten wird der Netzknoten im Abfrageblock 16 abgewiesen.

Bei dem bislang beschriebenen Verfahren vereint die Positionsnachricht auch die Merkmale einer Synchronisationsnachricht in sich. Das bedeutet, dass das exakte zeitliche Auftreten dieser Synchronisationsnachricht vom empfangenden Netzknoten gemessen und gegen den erwarteten Empfangszeitpunkt verglichen wird, um daraus die Abweichung zwischen der Lage der lokalen Kommunikationszeitpläne des empfangenden Netzknotens und des Referenz-Netzknotens und damit zwischen den lokalen Uhren zu bestimmen. Durch den Vergleich, d.h. die Differenzbildung, zweier aufeinanderfolgender Abweichungsterme, bestimmt aus der Synchronisationsnachricht des selben Netzknotens, kann ein Korrekturterm für den lokalen Uhrentakt bestimmt werden. Auch für die Synchronisationsnachricht gilt, dass ein empfangender Netzknoten in der Lage sein muss, die Synchronisationsnachricht eindeutig dem entsprechenden Referenz-Netzknoten zuordnen zu können. Für die Bestimmung der Korrekturterme aus allen gemessenen Abweichungen muss sichergestellt sein, dass nicht mehrere Synchronisationsnachrichten eines Netzknotens zu einem Ungleichgewicht bei der Mittelwertbildung führen. Ist in einem Netzwerk lediglich eine Synchxonisationsnachricht pro Netzknoten im Kommunikationszeitplan zulässig, so kann darauf verzichtet werde, dass aus der Synchronisationsnachricht der zugehörige Referenz-Netzknoten ermittelt werden kann.

Das Verfahren ist ebenfalls realisierbar, wenn die Merkmale der Positionsnachrichten und der Synchronisationsnachrichten nicht in einer Nachricht vereint sind, sondern diese Nachrichten getrennt im Kommunikationszeitplan eingetragen sind. Von einem Netzknoten im zweiten Pfad müssen dann immer beide Nachrichten innerhalb eines Kommunikationszyklus gesendet werden und die Netzknoten im ersten Pfad bzw. im zweiten Pfad müssen immer beide Nachrichten und deren Informationsgehalt in den Phasen der Blöcke 9 und 15 berücksichtigen. Eine Positionsnachricht innerhalb eines Zeitintervalls der Phasen der Blöcke 9 oder 15 ohne die zugehörige Synchronisationsnachricht (und andersherum) kann damit nicht zur Auswertung herangezogen werden.

## Patentansprüche

1. Netzwerk mit einem Verbindungs-Netzwerk und mehreren mit dem Verbindungs-Netzwerk gekoppelten Netzknoten,
die vor der Einbindung als aktiver Netzknoten jeweils zur Anpassung ihres lokalen Kommunikationszeitplans zu den Kommunikationszeitplänen wenigstens eines anderen Netzknoten vorgesehen sind, wobei
ein einzubindender Netzknoten zur Prüfung von Aktivität anderer Netzknoten und bei Feststellung keiner Aktivität als Referenz-Netzknoten fest zur Sendung in seinem Kommunikationszeitplan vorgegebene Positionsnachrichten für andere Netzknoten vorgesehen ist und
ein Netzknoten zur Einbindung als aktiver Netzknoten nach Erhalt von Positionsnachrichten zur Anpassung seines lokalen Kommunikationszeitplans an den des Referenz-Netzknotens und bei Abschluss einer positiven Prüfung auf Übereinstimmung seines eigenen Kommunikationszeitplans mit den Kommunikationszeitplänen wenigstens eines Teils der aktiven Netzknoten vorgesehen ist.

2. Netzwerk nach Anspruch 1,
**dadurch gekennzeichnet,**
**dass** ein Netzknoten bei der Prüfung auf Übereinstimmung seines eigenen Kommunikationszeitplans mit den Kommunikationszeitplänen wenigstens eines Teils der aktiven Netzknoten zur Zählung der Übereinstimmungen und der Abweichungen vorgesehen ist und
**dass** der Netzknoten nur dann zur Einbindung als aktiver Netzknoten vorgesehen ist, wenn die Zahl der Übereinstimmungen größer als die Zahl der Abweichungen ist oder keine Abweichung vorliegt.

3. Netzwerk nach Anspruch 2,
**dadurch gekennzeichnet,**
**dass** der Netzknoten für die Prüfung auf Übereinstimmung seines eigenen Kommunikationszeitplans mit den Kommunikationszeitplänen wenigstens eines Teils der aktiven Netzknoten zur Verwendung eines Zeitintervalls vorgesehen ist, in dem wenigstens einmal alle Positionsnachrichten der anderen an der Kommunikation beteiligten Netzknoten aussendbar sind.

4. Netzwerk nach Anspruch 1,
**dadurch gekennzeichnet,**
**dass** nach Detektion von keiner Aktivität ein einzubindender Netzknoten zur Prüfung vorgesehen ist, ob ein weiterer Netzknoten sich als Referenz-Netzknoten einbinden möchte.

5. Netzwerk nach Anspruch 4,
**dadurch gekennzeichnet,**
**dass** nach Detektion von keiner Aktivität ein einzubindender Netzknoten zur Aussendung einer Kollisionsnachricht vorgesehen ist.

6. Netzwerk nach Anspruch 4,
**dadurch gekennzeichnet,**
**dass** ein Netzknoten bei der Prüfung auf Einbindung als als Referenz-Netzknoten
- zuerst zur Aussendung seiner eigenen Positionsnachricht,
- zur Zählung von eintreffenden Positionsnachrichten und
- nur dann zur Einbindung als Referenz-Netzknoten vorgesehen ist, wenn die Zahl der korrekt empfangenen Positionsnachrichten größer als die Zahl der nicht korrekt empfangenen Positionsnachrichten ist oder alle Positionsnachrichten korrekt empfangen werden.

7. Netzknoten in einem Netzwerk mit einem Verbindungs-Netzwerk und mehreren weiteren mit dem Verbindungs-Netzwerk gekoppelten Netzknoten,
der vor der Einbindung als aktiver Netzknoten jeweils zur Anpassung seines lokalen Kommunikationszeitplans zu den Kommunikationszeitplänen wenigstens eines anderen Netzknoten vorgesehen sind, wobei
der Netzknoten zur Prüfung von Aktivität anderer Netzknoten und bei Feststellung keiner Aktivität als Referenz-Netzknoten fest zur Sendung in seinem Kommunikationszeitplan vorgegebene Positionsnachrichten für andere Netzknoten vorgesehen ist und
der Netzknoten zur Einbindung als aktiver Netzknoten nach Erhalt von Positionsnachrichten zur Anpassung seines lokalen Kommunikationszeitplans an den des Referenz-Netzknotens und bei Abschluss einer positiven Prüfung auf Übereinstimmung seines eigenen Kommunikationszeitplans mit den Kommunikationszeitplänen wenigstens eines Teils der aktiven Netzknoten vorgesehen ist.

8. Verfahren zur Einbindung eines Netzknotens als aktiver Netzknoten in einem Netzwerk mit einem Verbindungs-Netzwerk und mehreren weiteren mit dem Verbindungs-Netzwerk gekoppelten Netzknoten,
bei dem der Netzknoten vor der Einbindung als aktiver Netzknoten jeweils seinen lokalen Kommunikationszeitplan zu den Kommunikationszeitplänen wenigstens eines anderen Netzknoten anpasst,
bei dem der Netzknoten Aktivitäten anderer Netzknoten prüft und bei Feststellung keiner Aktivität als Referenz-Netzknoten in seinem Kommunikationszeitplan vorgegebene Positionsnachrichten für andere Netzknoten ausendet und
bei dem der Netzknoten als aktiver Netzknoten eingebunden wird, wenn er nach Erhalt von Positionsnachrichten seinen lokalen Kommunikationszeitplan an den des Referenz-Netzknotens angepasst und die Prüfung auf Übereinstimmung seines eigenen Kommunikationszeitplans mit den Kommunikationszeitplänen wenigstens eines Teils der aktiven Netzknoten positiv abgeschlossen hat.

## Claims

1. Network having an interconnecting network and a plurality of network nodes which are coupled to the interconnecting network
and are each provided, before integration as an active network node, for adapting their local communications time schedule to the communications time schedules of at least one other network node, wherein
a network node which is to be integrated is provided for checking activity of other network nodes, and when no activity is detected position messages which are permanently predefined for transmission in its communications time schedule, for other network nodes, are provided as a reference network node, and
a network node is provided for integration as an active network node after the reception of position messages in order to adapt its local communications time schedule to that of the reference network node and when a positive check for correspondence between its own communications time schedule and the communications time schedules of at least some of the active network nodes is concluded.

2. Network according to Claim 1, **characterized in that** a network node is provided for counting the correspondences and the deviations during the checking for correspondence between its own communications time schedule and the communications time schedules of at least some of the active network nodes, and
**in that** the network node is provided for integration as an active network node only if the number of correspondences is greater than the number of deviations or there is no deviation.

3. Network according to Claim 2, **characterized in that** the network node is provided for checking for correspondence between its own communications time schedule and the communications time schedules of at least some of the active network nodes in order to use a time interval in which all the position messages of the other network nodes which are involved in the communication can be emitted at least once.

4. Network according to Claim 1, **characterized in that**, after no activity is detected, a network node which is to be integrated is provided for checking whether a further network node would like to be integrated as a reference network node.

5. Network according to Claim 4, **characterized in that**, after no activity is detected, a network node which is to be integrated is provided for emitting a collision message.

6. Network according to Claim 4, **characterized in that**, during the checking for integration as a reference network node, a network node is provided
- firstly for emitting its own position message,
- for counting incoming position messages and
- is provided for integration as a reference network node only if the number of correctly received position messages is greater than the number of incorrectly received position messages or all the position messages are received correctly.

7. Network node in a network having an interconnecting network and a plurality of further network nodes which are coupled to the interconnecting network
and are each provided, before integration as an active network node, for adapting their local communications time schedule to the communications time schedules of at least one other network node, wherein
the network node is provided for checking activity of other network nodes and when no activity is detected position messages which are permanently provided for transmission in its communications time schedule, for other network nodes, are provided as a reference network node, and
the network node is provided for integration as an active network node after the reception of position messages for adapting its local communications time schedule to that of the reference network node and when a positive check for correspondence between its own communications time schedule and the communications time schedules of at least some of the active network nodes is concluded.

8. Method for integrating a network node as an active network node in a network having an interconnecting network and a plurality of further network nodes which are coupled to the interconnecting network,
in which, before integration as an active network node, the network node in each case adapts its local communications time schedule to the communications time schedules of at least one other network node,
in which the network node checks activities of other network nodes and when no activity is detected it emits position messages which are predefined in its communications time schedule as a reference network node for other network nodes, and
in which the network node is integrated as an active network node if, after the reception of position messages, it adapts its local communications time schedule to that of the reference network node and the checking for correspondence between its own communications time schedule and the communications time schedules of at least some of the active network nodes has ended positively.

## Revendications

1. Réseau comprenant un réseau de liaison et plusieurs noeuds de réseau couplés au réseau de liaison qui, avant l'intégration en tant que noeud de réseau actif, sont à chaque fois prévus pour adapter leur échéancier de communication local aux échéanciers de communication d'au moins un autre noeud de réseau, un noeud de réseau à intégrer étant prévu pour contrôler l'activité des autres noeuds de réseau et, s'il ne constate aucune activité, en tant que noeud de réseau de référence fixe pour envoyer aux autres noeuds de réseau des informations de position prédéfinies dans son échéancier de communication et un noeud de réseau étant prévu pour être intégré en tant que noeud de réseau actif après réception des informations de position en vue d'adapter son échéancier de communication local au noeud de réseau de référence et suite à un contrôle positif de la concordance de son propre échéancier de communication avec les échéanciers de communication d'au moins une partie des noeuds de réseau actifs.

2. Réseau selon la revendication 1, **caractérisé en ce que** lors du contrôle de la concordance de son propre échéancier de communication avec les échéanciers de communication d'au moins une partie des noeuds de réseau actifs, un noeud de réseau est prévu pour compter les concordances et les différences et que le noeud de réseau n'est prévu pour être intégré en tant que noeud de réseau actif que lorsque le nombre de concordances est supérieur au nombre de différences ou lorsqu'il n'existe pas de différence.

3. Réseau selon la revendication 2, **caractérisé en ce que** le noeud de réseau destiné au contrôle de la concordance de son propre échéancier de communication avec les échéanciers de communication d'au moins une partie des noeuds de réseau actifs est prévu pour utiliser un intervalle de temps dans lequel peuvent être émises au moins une fois toutes les informations de position des autres noeuds de réseau participant à la communication.

4. Réseau selon la revendication 1, **caractérisé en ce qu'**après la détection d'aucune activité, il est prévu un noeud de réseau à intégrer destiné à vérifier si un autre noeud de réseau souhaite s'intégrer en tant que noeud de réseau de référence.

5. Réseau selon la revendication 4, **caractérisé en ce qu'**après la détection d'aucune activité, il est prévu un noeud de réseau à intégrer destiné à émettre une information de collision.

6. Réseau selon la revendication 4, **caractérisé en ce que** lors du contrôle de l'intégration, un noeud de réseau est prévu en tant que noeud de réseau de référence
- seulement en vue d'envoyer sa propre information de position,
- pour le comptage des informations de position entrantes et
- ensuite seulement pour être intégré en tant que noeud de réseau de référence si le nombre d'informations de position reçues correctement est supérieur au nombre d'informations de position reçues incorrectement ou si toutes les informations de position ont été reçues correctement.

7. Noeud de réseau dans un réseau comprenant un réseau de liaison et plusieurs autres noeuds de réseau couplés au réseau de liaison qui, avant l'intégration en tant que noeud de réseau actif, sont à chaque fois prévus pour adapter son échéancier de communication local aux échéanciers de communication d'au moins un autre noeud de réseau, le noeud de réseau étant prévu pour contrôler l'activité des autres noeuds de réseau et, s'il ne constate aucune activité, en tant que noeud de réseau de référence fixe pour envoyer aux autres noeuds de réseau des informations de position prévues dans son échéancier de communication et le noeud de réseau étant prévu pour être intégré en tant que noeud de réseau actif après réception des informations de position en vue d'adapter son échéancier de communication local à celui du noeud de réseau de référence et suite à un contrôle positif de la concordance de son propre échéancier de communication avec les échéanciers de communication d'au moins une partie des noeuds de réseau actifs.

8. Procédé pour intégrer un noeud de réseau en tant que noeud de réseau actif dans un réseau comprenant un réseau de liaison et plusieurs autres noeuds de réseau couplés au réseau de liaison avec lequel, avant l'intégration en tant que noeud de réseau actif, le noeud de réseau adapte à chaque fois son échéancier de communication local aux échéanciers de communication d'au moins un autre noeud de réseau, avec lequel le noeud de réseau contrôle l'activité des autres noeuds de réseau et, s'il ne constate aucune activité, envoie en tant que noeud de réseau de référence des informations de position prédéfinies dans son échéancier de communication aux autres noeuds de réseau et avec lequel le noeud de réseau est intégré en tant que noeud de réseau actif si, après réception des informations de position, il a adapté son échéancier de communication local à celui du noeud de réseau de référence et a terminé avec un résultat positif le contrôle de la concordance de son propre échéancier de communication avec les échéanciers de communication d'au moins une partie des noeuds de réseau actifs.
